# NEUE EUROPÄISCHE PATENTSCHRIFT

(11) **EP 1 989 740 B2**
(45) Veröffentlichungstag und Bekanntmachung des Hinweises auf die Entscheidung über den Einspruch: **22.05.2019**
(45) Hinweis auf die Patenterteilung: 14.10.2009
(21) Anmeldenummer: 07726561.9
(22) Anmeldetag: 28.02.2007
(51) Int. Cl.: H01L 31/18, H01L 23/544

(54) **SOLARZELLENMARKIERVERFAHREN UND SOLARZELLE**
SOLAR CELL MARKING METHOD, AND SOLAR CELL
PROCEDE DE MARQUAGE DE CELLULES SOLAIRES ET CELLULES SOLAIRES

(30) Priorität: 28.02.2006 DE 102006009584
(43) Veröffentlichungstag der Anmeldung: 12.11.2008
(73) Patentinhaber: Hanwha Q CELLS GmbH, 06766 Bitterfeld-Wolfen (DE)
(72) Erfinder: MÜLLER, Jörg, 06792 Sandersdorf (DE); PATZLAFF, Toralf, 06114 Halle (DE)
(74) Vertreter: Peterreins Schley
(86) Internationale Anmeldenummer: PCT/EP2007/051925
(87) Internationale Veröffentlichungsnummer: WO 2007/099138

(56) Entgegenhaltungen:
- EP-A- 1 427 014
- US-A- 4 568 409
- US-A1- 2004 166 444
- US-B1- 6 235 637

## Beschreibung

Die Erfindung betrifft ein Solarzellenmarkierverfahren gemäß dem Oberbegriff des Anspruchs 1 sowie eine Solarzelle gemäß dem Oberbegriff des Anspruchs 17.

US 6,235,637 B1 offenbart ein Verfahren zur Markierung von Halbleiterwafern mittels eines Lasers. Hierzu wird zunächst die Waferoberfläche mit Fotolack beschichtet. Anschließend wird in einer Ausführungsform mittels Lasereinschreibung eine sich bis zur Waferoberfläche und gegebenenfalls darüber hinaus in die Waferoberfläche erstreckende Schneise in die Fotolackschicht eingeschrieben. Gemäß einer alternativen Ausführungsform wird zunächst die Fotolackschicht an einem Markierbereich am Rand des Wafers entfernt. In diesem Markierbereich wird anschließend mittels eines Lasers eine Markierung eingeschrieben.

US 4,568,409 A beschreibt die Laserstrukturierung von Dünnschichten zur Herstellung eines Dünnschichtsotarmoduls mit monolithischer Verschaltung. Hierzu werden Laser-Scribes insbesondere in Metallisierungsschichten eingeschrieben.

US 2004/166444 A1 betrifft die Positionierung einer Markierung auf einem Substrat, das in einem inline-Verfahren prozessiert wird. Das Substrat dient anschließend in einem Substrat- oder Superstrataufbau als Träger für Dünnschichtsolarzellen, die zu einem Solarmodul verschaltet sind.

Aus EP 1 089 346 A2 ist ein Solarzellen-Markierverfahren bekannt, bei dem zunächst ein Substrat mit einer Substratoberfläche zum Herstellen einer Solarzelle, die eine aktive Zone aufweist, bereitgestellt wird und anschließend mindestens eine Vertiefung in der Substratoberfläche unter Verwendung von Laserstrahlung erzeugt wird. Die mindestens eine Vertiefung bildet eine Markierung zum Markieren der Solarzelle, und das Erzeugen der Vertiefung wird vor einem Durchführen eines Solarzellen-Herstellungsprozesses oder während eines Durchführens eines Solarzellen-Herstellungsprozesses vorgenommen. Dieses Solarzellen-Markierverfahren ist jedoch für den Einsatz so genannter Dünnschichtsolarmodule optimiert. Die Dünnschichtsolarmodule umfassen eine Mehrzahl von Dünnschichtsolarzellen, die monolithisch in Serie geschaltet sind. Diese Dünnschichtsolarzellen werden auf einem als Glasscheibe ausgebildeten Substrat abgeschieden. Damit die mittels Laserstrahlung eingravierte Markierung die Funktionsweise der Dünnschichtsolarzellen nicht beeinträchtigt, wird die Markierung im Randbereich der Glasscheibe positioniert, der nicht zur Stromerzeugung des Solarmoduls beiträgt.

JP 2004200514 A beschreibt ein Herstellungsverfahren für Solarzellen. Es werden Unterscheidungsmarkierungen beschrieben. Die Verwendung eines Lasers wird mit Bezug auf die Rückseite und den Rand erwähnt.

US 4,626,613 beschreibt die Verwendung eines Lasers zum Erzeugen von Rillen und weiteren Solarzellenstrukturen in einem Wafer im Rahmen der Herstellung einer Solarzelle.

Da die Randbereiche jedoch nicht zur Stromerzeugung der Solarzellen beitragen, ist es wünschenswert, diese Randbereiche so klein wie möglich auszugestalten.

Der vorliegenden Erfindung liegt die Aufgabe zu Grunde, ein einfaches Solarzellen-Markierverfahren zu schaffen, das es ermöglicht, die nicht zur Stromerzeugung beitragenden Randbereiche der Solarzelle zu minimieren.

Diese Aufgabe wird durch ein Solarzellen-Markierverfahren mit den Merkmalen des Anspruchs 1 gelöst.

Erfindungsgemäß ist vorgesehen, dass das Substrat als Halbleiterwafer mit einer Waferoberfläche ausgebildet ist, und die Markierung auf der Waferoberfläche derart positioniert wird, dass die Markierung in der aktiven Zone der aus dem Halbleiterwafer gebildeten Solarzelle liegt.

Dadurch, dass Halbleiterwafer als Substrate verwendet werden, lässt sich die auf der Substratoberfläche generierte aktive Zone der Solarzelle bis kurz vor den Rand des Substrates maximieren. Die im Vergleich zu Dünnschichtsolarmodulen unterschiedlichen Prozessschritte bei der Herstellung von Halbleiterwafer-Solarzellen erlauben die Positionierung einer Markierung in der aktiven Zone der Solarzelle, wobei die Markierung in Form mindestens einer in die Waferoberfläche eingebrachten, mittels Laserstrahlung generierten Vertiefung hergestellt wird.

Abhängig davon in welchem Prozessstadium die Markierung während der Herstellung der Halbleiterwafer-Solarzellen in die Waferoberfläche eingebracht wird, lässt sich der Herstellungsprozess durch das Auslesen der Markierung unterschiedlich weit zurückverfolgen.

Als Halbleiterwafer kommt poly- oder monokristallines Material in Frage, insbesondere natürlich Silizium aber auch Germanium und andere als Wafer bekannte Halbleitermaterialien. Ebenso ist es denkbar einen per String-Ribbon-Verfahren hergestellten Halbleiterwafer einzusetzen.

Das Auslesen der Markierungen wird bevorzugt am Ende des Solarzellen-Herstellungsprozesses vorgenommen, ist aber auch zwischen einzelnen Teilschritten während der Prozessierung möglich. Bei der Weiterverarbeitung der Solarzellen, beispielsweise für die Herstellung eines Solarmoduls ergibt sich die gleiche Möglichkeit. Die in Solarmodulen angeordneten Solarzellen sind mit ihren aktiven Zonen derart orientiert, dass diese möglichst gut durch einfallende Lichtstrahlung erreicht werden. Dadurch ist als Nebeneffekt sichergestellt, dass die Markierungen der Solarzellen in jedem Solarmodul mit Lesevorrichtungen, die mit optischen Bildgebern arbeiten, einfach auslesbar sind. Dadurch ist eine Langzeitverfolgung der Solarzellen in Solarmodulen über die gesamte Produktlebensdauer möglich.

Das Verfahren bezieht sich sowohl auf den Fall, dass auf einem Halbleiterwafer nur eine einzige Solarzelle hergestellt wird und auf den Fall dass auf einem Halbleiterwafer eine Mehrzahl von Solarzellen hergestellt wird. Bei einer Mehrzahl von Solarzellen können eine oder mehrere Markierungen erzeugt werden.

Bevorzugt wird die mindestens eine Vertiefung mit einer solchen Tiefe erzeugt, dass die durch sie gebildete Markierung auch nach Durchführen des gesamten Herstellungsprozesses mittels einer opto-elektronischen Leseeinrichtung lesbar ist. Dadurch lässt sich mit ein und derselben Vertiefung der gesamte Herstellungsprozess einer Halbleiterwafer-Solarzelle verfolgen. Die Prozessschritte während der Herstellung können sowohl, beispielsweise als Abscheidung von Schichten, Material auf die Waferoberfläche aufbringen als auch, beispielsweise in Form von Ätzverfahren, Material von der Waferoberfläche abtragen. Abhängig von Stärke (Schichtdicken beim Abscheiden und Ätzen) und Isotropie der Materialveränderung und unter Berücksichtigung der Anforderung seitens der zum Einsatz kommenden Leseeinrichtung wird die Tiefe der Vertiefungen ausgewählt.

Eine besonders vorteilhafte Variante des Verfahrens ist **dadurch gekennzeichnet, dass** nach dem Erzeugen der mindestens einen Vertiefung ein Ätzschritt derart vorgesehen ist, dass die durch Energieeintrag beeinflussten Zonen an der Waferoberfläche im Bereich der Vertiefung vollständig entfernt werden. Bei der Erzeugung der Vertiefungen wird die Mikrostruktur des Halbleitermaterials im Bereich der Waferoberfläche durch Energieeintrag beeinflusst. Dadurch wird insbesondere die Ladungsträgerlebensdauer als wichtige Größe für die Funktion der Solarzelle beeinflusst. Dadurch dass die durch Energieeintrag beeinflussten Zonen an der Waferoberfläche entfernt werden, lässt sich eine auf den Energieeintrag der Laserstrahlung zurückzuführende Beeinträchtigung der Solarzelle vermeiden.

Bevorzugt ist der Ätzschritt zur Entfernung der durch Energieeintrag beeinflussten Zone derart ausgebildet, dass die Waferoberfläche im Bereich der Vertiefungen mit einer höheren Ätzrate geätzt wird als außerhalb. Dadurch lässt sich die Ausprägung der Vertiefungen in der Waferoberfläche weiter verstärken.

Es ist vorteilhaft, dass der Ätzschritt als nasschemisches Polieren oder als Trockenätzschritt, insbesondere als Plasmaätzverfahren, durchgeführt wird. Hier lassen sich Bearbeitungsverfahren, die beispielsweise aus der Mikrosystemtechnik bekannt sind, zur kontrollierten Bearbeitung der Waferoberfläche einsetzen.

Eine besonders vorteilhafte Variante des Herstellungsverfahrens sieht vor, dass durch den Ätzschritt zusätzlich die mit der Markierung versehene Waferoberfläche texturiert wird. Durch die Kombination von Texturierung mit Entfernung der durch Energieeintrag beeinflussten Zonen lässt sich das Herstellungsverfahren ökonomischer anwenden.

Bevorzugte Ausführungsformen des Verfahrens sind **dadurch gekennzeichnet, dass** die mindestens eine Vertiefung durch Laserabtrag mit einer Tiefe von mehr als 8 µm, bevorzugt mehr als 12 µm, besonders bevorzugt zwischen 15 und 30 µm erzeugt wird.

Im Zusammenhang mit den vorangehend benannten Parametern zur Tiefe der Vertiefungen ist es vorteilhaft, wenn das Größenverhältnis von der Tiefe zum Durchmesser der mindestens einen Vertiefung bei der Erzeugung der Vertiefung größer 1:12, bevorzugt größer 1:10 und besonders bevorzugt im Bereich von 1:7 bis 1:3 beträgt. Im Falle von Vertiefungen, die keine runde Kontur aufweisen, ist das Merkmal des Durchmessers im Sinne der vorliegenden Erfindung als das kleinste Abstandsmaß gegenüber liegender Randbereiche der Vertiefung zu verstehen. Durch die genannten Größenverhältnisse ist sichergestellt, dass die Markierung mit heutzutage üblichen Leseeinrichtungen für Markierungen, beispielsweise opto-elektronische Scanner für Optical Character Recognition (OCR), während und nach dem Durchlaufen aller Prozessschritte bei der Herstellung von Halbleiterwafer-Solarzellen sicher auslesbar ist.

Ein weiterer wichtiger Aspekt ist der Abstand der einzelnen Vertiefungen zueinander, wenn eine Mehrzahl von Vertiefungen zur Bildung der Markierung eingesetzt wird. Entlang des minimalen Abstands zweiter benachbarter Vertiefungen erstreckt sich üblicherweise ein Steg, der die beiden Vertiefungen voneinander trennt. Für den beim Auslesen der Markierung erforderlichen Kontrast ist eine ausreichende Stegbreite erforderlich. Benachbarte Vertiefungen sollte mit einem Mindestabstand von rund 20 bis 30 µm hergestellt werden. Dabei ist zu berücksichtigen, dass der Abstand der Vertiefungen durch einen isotropen Ätzschritt zur Entfernung der durch Laserstrahlung beinftussten Zonen noch abnimmt. Ist der Ätzschritt hingegen anisotrop ausgebildet, so bleibt der Abstand zweier Vertiefungen zueinander im Wesentlichen gleich.

Ein bevorzugtes Solarzellen-Markierverfahren sieht vor, dass der Solarzellen-Herstellungsprozess folgende Schritte umfasst: die Erzeugung eines großflächigen p-n-Übergangs auf der mit der Markierung versehenen Waferoberfläche, beispielsweise durch thermische Diffusion mit einem Dotierstoff, insbesondere mit Phosphor; das Abscheiden einer Antireflexionsschicht auf der mit der Markierung versehenen Waferoberfläche, beispielsweise in Form einer Dünnschicht aus Siliziumnitrid oder Titandioxid und das Aufbringen, Trocknen und Einbrennen einer metallhaltigen Paste in Form eines Leiterbahnen aufweisenden metallischen Elektrodengitters (Frontgrid) auf der mit der Markierung versehenen Waferoberfläche mit der aktiven Zone. Es ist klar, dass von den vorangehend gemachten Ausführungen abweichende, andere Ausbildungen des p-n-Übergangs oder der Herstellung des Elektrodengitters realisierbar sind. So lassen sich auch eine Mehrzahl von p-n-Übergangen auf einem Halbleiterwafer ausbilden bzw. das Elektrodengittern an Stelle des Siebdruckverfahrens durch eine Schichtabscheidung mit anschließender Schichtstrukturierung realisieren.

Für die vorangehend genannten Verfahren ist es bevorzugt, wenn die Leiterbahnen beabstandet zur Markierung angeordnet werden. Dadurch wird ausgeschlossen, dass die Leiterbahnen bei Ihrer Herstellung aufgrund der an der Waferoberfläche bestehenden Vertiefungen in ihrer elektrischen Leitfähigkeit beeinträchtigt werden.

Eine weitere vorteilhafte Variante des Verfahrens sieht im Hinblick auf die Leiterbahnen vor, dass die Leiterbahnen äquidistant zueinander angeordnet werden.

Eine weitere Variante des Markierverfahrens sieht im Hinblick auf die Anordnung der Leiterbahnen vor, dass die Markierung mittig auf dem Halbleiterwafer angeordnet wird und die Leiterbahnen derart angeordnet werden, dass eine erste mittige Leiterbahn von der einen Seite der Waferoberfläche auf die Markierung zuläuft und eine zweite mittige Leiterbahn von der gegenüberliegenden Seite der Waferoberfläche auf die Markierung zuläuft, wobei die erste mittige Leiterbahn und die zweite mittige Leiterbahn vor einem Kontakt mit der Markierung in entgegen gesetzte Richtungen abknicken und in jeweils benachbarte Leiterbahnen einmünden. Auf diese Weise lassen sich Markierungen in der aktiven Zone der Solarzellen positionieren, deren Ausmaße breiter sind als der maximale Abstand zweier benachbarter Leiterbahnen.

Bevorzugt wird die Markierung aus einer Mehrzahl von Vertiefungen derart aufgebaut, dass die Markierung in Form eines Datamatrix-Codes oder eines Strichcodes ausgebildet wird. Die Vertiefungen können eine im Prinzip beliebige Form aufweisen, zum Beispiel punkt- oder strichförmig sein. Auf diese Weise lassen sich in der Praxis bewährte Markierungssysteme für Halbleiterwafer-Solarzellen einsetzen. Bevorzugt wird die Markierung als 14x14 Datamatrix-Code mit einer Kantenlänge von im Wesentlichen 2 mm x 2 mm erzeugt.

Alternativ oder kumulativ wird die Markierung als eine mittels OCR-Verfahren lesbare Serienkennzeichnung erzeugt, die eine Mehrzahl an Zeichen aus Ziffern und/oder Buchstaben umfasst, wobei die Zeichen mit einer Höhe von zirka einem Millimeter ausgebildet werden.

Eine bevorzugte Variante des Markierverfahrens ist **dadurch gekennzeichnet, dass** eine Mehrzahl von Markierungen auf der Waferoberfläche erzeugt wird. Dadurch lässt sich der Halbleiterwafer beispielsweise in verschiedenen Prozessstadien mit verschiedenen Informationen versehen.

Die Aufgabe der vorliegenden Erfindung wird weiterhin durch eine Solarzelle mit den Merkmalen des Anspruchs 17 gelöst.

Erfindungsgemäß ist vorgesehen, dass die Solarzelle aus einem Halbleiterwafer mit einer Waferoberfläche hergestellt und die Markierung in der Waferoberfläche im Bereich der aktiven Zone der Solarzelle ausgebildet ist.

Dadurch, dass die Solarzelle aus einem Halbleiterwafer als Substrate aufgebaut ist, lässt sich die auf der Substratoberfläche generierte aktive Zone der Solarzelle bis kurz vor den Rand des Substrates maximieren. Die im Vergleich zu Dünnschichtsolarmodulen unterschiedlichen Prozessschritte bei der Herstellung von Halbleiterwafer-Solarzellen erlauben die Positionierung einer Markierung in der aktiven Zone der Solarzelle, wobei die Markierung in Form mindestens einer in die Waferoberfläche eingebrachten, mittels Laserstrahlung generierten Vertiefung ausgebildet ist.

Bevorzugt umfasst die Solarzelle mindestens eine Vertiefung mit einer solchen Tiefe, dass die durch die Vertiefung gebildete Markierung auch nach Durchführen des gesamten Solarzellen-Herstellungsprozesses mittels einer opto-elektronischen Leseeinrichtung lesbar ist. Dadurch lässt sich mit ein und derselben Vertiefung der gesamte Herstellungsprozess einer Halbleiterwafer-Solarzelle verfolgen. Die Prozessschritte während der Herstellung können sowohl, beispielsweise als Abscheidung von Schichten, Material auf die Waferoberfläche aufbringen als auch, beispielsweise in Form von Ätzverfahren, Material von der Waferoberfläche abtragen. Abhängig von Stärke (Schichtdicken beim Abscheiden und Ätzen) und Isotropie der Materialveränderung und unter Berücksichtigung der Anforderung seitens der zum Einsatz kommenden Leseeinrichtung ist die Tiefe der Vertiefungen ausgebildet.

Bevorzugt ist die Solarzelle derart ausgebildet, dass angrenzende Bereiche im Innern der mindestens einen Vertiefung eine multikristalline oder eine monokristalline Mikrostruktur aufweisen, die durch den Eintrag von Laserenergie im Wesentlichen unbeeinflusst ist. Bei der Erzeugung der Vertiefungen wird die Mikrostruktur des Halbleitermaterials im Bereich der Waferoberfläche durch Energieeintrag beeinflusst. Dadurch wird insbesondere die Ladungsträgerlebensdauer als wichtige Größe für die Funktion der Solarzelle beeinflusst. Dadurch dass die durch Energieeintrag beeinflussten Zonen an der Waferoberfläche entfernt wurden, liegen die angrenzenden Bereiche im Innern der mindestens einen Vertiefung als multi- oder monokristalline Halbleiter vor, die vom Energieeintrag der Laserstrahlung unbeeinflusst sind. Auf diese Weise ist die Funktion der Solarzelle nicht durch den Energieeintrag der Laserstrahlung beeinträchtigt.

Eine bevorzugte Variante der Solarzelle sieht vor, dass die Waferoberfläche im Innern der mindestens einen Vertiefung texturiert ausgebildet ist. Durch die Texturierung lässt sich in bekannter Weise der Wirkungsgrad der Solarzelle erhöhen.

Es ist vorteilhaft, dass die Solarzelle mindestens eine Vertiefung mit einer Tiefe von mehr als 8 µm, bevorzugt mehr als 12 µm, besonders bevorzugt zwischen 15 und 30 µm umfasst. Im Zusammenhang mit der Tiefe der Vertiefungen ist es für die Solarzelle weiterhin vorteilhaft, dass die mindestens eine Vertiefung derart ausgebildet ist, dass das Größenverhältnis von der Tiefe zum Durchmesser der mindestens einen Vertiefung größer 1:12, bevorzugt größer 1:10 und besonders bevorzugt im Bereich von 1:7 bis 1:3 beträgt. Dadurch ist sichergestellt, dass die Markierung mit heutzutage üblichen Leseeinrichtungen für Markierungen, beispielsweise opto-elektronische Scanner für Optical Character Recognition (OCR), während und nach dem Durchlaufen aller Prozessschritte bei der Herstellung von Halbleiterwafer-Solarzellen sicher auslesbar ist.

Ein weiterer wichtiger Aspekt ist der Abstand der einzelnen Vertiefungen zueinander, wenn eine Mehrzahl von Vertiefungen zur Bildung der Markierung vorgesehen ist. Entlang des minimalen Abstands zweiter benachbarter Vertiefungen erstreckt sich üblicherweise ein Steg, der die beiden Vertiefungen voneinander trennt. Für den beim Auslesen der Markierung erforderlichen Kontrast ist eine ausreichende Stegbreite erforderlich. Benachbarte Vertiefungen sollten mit einem Mindestabstand von rund 20 bis 30 µm ausgebildet sein.

Eine bevorzugte Ausführungsform der Solarzelle umfasst einen großflächigen p-n-Übergang auf der der Markierung zugewandten Seite des Halbleiterwafers, eine Antireflexionsschicht auf der mit der Markierung versehenen Waferoberfläche und ein metallisches Elektrodengitter (Frontgrid) mit einer Mehrzahl von Leiterbahnen auf der mit der Markierung versehenen Waferoberfläche mit der aktiven Zone, wobei die Leiterbahnen beabstandet zur Markierung verlaufen. Es ist selbstverständlich, dass insbesondere im Hinblick auf die Ausgestaltung und Positionierung des p-n-Übergangs auf dem Halbleiterwafer eine Vielzahl weiterer Varianten existiert, die hier nicht weiter beschrieben wird.

Ein Beispiel besteht in einer einzelnen Solarzelle mit einer Markierung in Form eines zentrisch auf der Vorderseite in der aktiven Zone der Solarzelle angeordneten Datamatrix Codes. Das Frontgrid der Zelle wäre dann so gestaltet, dass die im mittleren Bereich der Solarzelle verlaufenden Leiterbahnen des Frontgrids um die Datamatrix Code-Markierung herum verlaufen.

Eine Variante der vorangehend beschriebenen bevorzugten Ausführungsform der Solarzelle sieht vor, dass die Markierung mittig auf dem Halbleiterwafer angeordnet ist und die Leiterbahnen derart angeordnet sind, dass eine erste mittige Leiterbahn von der einen Seite der Waferoberfläche auf die Markierung zuläuft und eine zweite mittige Leiterbahn von der gegenüberliegenden Seite der Waferoberfläche auf die Markierung zuläuft, wobei die erste mittige Leiterbahn und die zweite mittige Leiterbahn vor einem Kontakt mit der Markierung in entgegen gesetzte Richtungen abknicken und in jeweils benachbarte Leiterbahnen einmünden. Auf diese Weise lassen sich auch Markierungen in der aktiven Zone der Solarzellen vorsehen, deren Ausmaße breiter sind als der maximale Abstand zweier benachbarter Leiterbahnen.

Die Markierung der Solarzelle ist bevorzugt aufgebaut aus einer Mehrzahl von Vertiefungen und ist in Form einer Serienkennzeichnung, eines Datamatrix-Codes oder eines Strichcodes ausgebildet. Dadurch lassen sich unterschiedliche aus dem Stand der Technik bekannte Markierungssysteme mit ihren Vor- und Nachteilen für den Einsatz auf einer Halbleiterwafer-Solarzelle implementieren.

Eine vorteilhafte Variante der Solarzelle sieht vor, dass die Markierung als 14x14 Datamatrix-Code mit einer Kantenlänge von im Wesentlichen 2mm x 2mm ausgebildet ist. Alternativ oder kumulativ ist die Markierung als eine mittels einer elektro-optischen Leseeinrichtung lesbare Serienkennzeichnung ausgebildet, die eine Mehrzahl an Zeichen aus Ziffern und/oder Buchstaben umfasst, wobei die Zeichen mit einer Höhe von zirka einem Millimeter ausgebildet werden.

Eine weitere Variante der Solarzelle ist mit einer Mehrzahl von Markierungen auf der Waferoberfläche ausgebildet. Dadurch lassen sich unterschiedliche Markierungssysteme mit ihren jeweiligen Vor- und Nachteilen für eine Halbleiterwafer-Solarzelle kombinieren.

Darüber hinaus kann über die Dimensionierung der Markierungen der Tatsache Rechnung getragen werden, dass der Zeitbedarf für das Markieren und Auslesen der Markierung den Durchsatz bei der Herstellung der Solarzellen nicht verringern sollte. Die Markierung sollte hinsichtlich ihrer Herstellung und des Auslesen zu einer für den Solarzellen-Bereich typischen Zykluszeit einer in-line-Produktionsanlage von 1,5 s passend ausgelegt sein. Dies gilt sowohl für das Solarzellen-Markierungsverfahren als auch für die mit der Markierung versehene Solarzelle.

Die vorliegende Erfindung wird im Folgenden anhand von Ausführungsbeispielen unter Bezugnahme auf die Figuren näher erläutert. Es zeigt:
- Fig. 1: einen Ausschnitt der aktiven Zone 5 einer ersten Ausführungsform der Solarzelle;
- Fig. 2: einen im Vergleich zur Figur 1 vergrößert dargestellten Ausschnitt der aktiven Zone 5 einer zweiten Ausführungsform der Solarzelle;
- Fig. 3a: eine nicht maßstabsgetreue schematische Schnittdarstellung durch drei benachbart angeordnete Vertiefungen 21 auf der Oberfläche eines noch unbehandelten Halbleiterwafers;
- Fig. 3b: die Darstellung der drei benachbarten Vertiefungen 21 aus Figur 3a nach einem Ätzschritt;
- Fig. 3c: die Darstellung der benachbarten Vertiefungen 21 aus Figur 3b nach dem Schritt der Eindiffusion eines Dotierstoffes zur Bildung eines p-n-Übergangs;
- Fig. 3d: die nicht maßstabsgetreue schematische Schnittansicht dreier benachbarter Vertiefungen 21 aus Figur 2 entlang der Schnittlinie IIId - IIId und
- Fig. 4: eine schematische Darstellung von Verfahrensschritte zur Herstellung von Solarzellen gemäß den Darstellungen der Figuren 1 bis 3d.

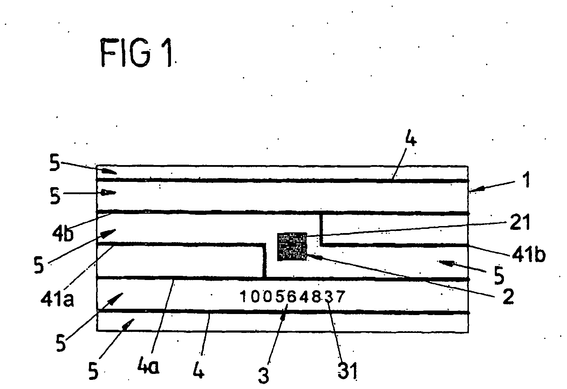

Die Figur 1 stellt einen Ausschnitt der aktiven Zone 5 einer Solarzelle 1 dar. Die Solarzelle 1 weist eine in der aktiven Zone 5 auf der Waferoberfläche angeordnete Datamatrix-Code-Markierung 2 auf, die aus einzelnen Vertiefungen 21 besteht. Die Solarzelle 1 wurde aus einem multi- oder monokristallinen Siliziumwafer hergestellt, in dem bereits vor der eigentlichen Prozessierung zum Herstellen der Solarzelle 1 die Vertiefungen 21 per Laserabtrag erzeugt wurden. Die Datamatrix-Code-Markierung 2 weist eine Mehrzahl benachbarter Vertiefungen 21 auf, die jeweils die Form eines Punktes haben und in einer zweidimensionalen periodisch aufgebauten Matrixstruktur angeordnet sind. Die einzelnen Vertiefungen 21 stellen dabei einzelne Segmente bzw. Informationseinheiten eines Datamatrix-Codes dar.

Zusätzlich ist unterhalb der Datamatrix-Code-Markierung 2 eine Markierung in Form einer in die Waferoberfläche der Solarzelle 1 eingebrachten Serienkennung 3 vorgesehen. Die Serienkennung 3 ist ebenfalls im Bereich der aktiven Zone 5 der Solarzelle 1 angeordnet. Im vorliegenden Fall wird die Serienkennung 3 durch die Kombination von Vertiefungen 31 in Form von Ziffern gebildet. Es ist jedoch ebenso denkbar, eine beliebige Kombination von Ziffern und Buchstaben beliebiger Sprachen einzusetzen. Die die Serienkennung 3 bildenden Vertiefungen 31 sind wie die Vertiefungen 21 der Datamatrix-Code-Markierung 2 per Laserabtrag im rohen Siliziumwafer vor dem eigentlichen Prozess zum Herstellen der Solarzelle 1 an einer Position erzeugt worden, die in der aktiven Zone 5 der noch zu bildenden Solarzelle 1 liegt. Die Serienkennung 3 besteht aus einer Folge benachbart angeordneter Vertiefungen 31, die jeweils die Form einer Ziffer haben. Diese Vertiefungen 31 sind bevorzugt so ausgebildet, dass sie mittels einer, beispielsweise elektro-optisch wirkenden, OCR-Leseeinrichtung automatisch auslesbar sind. Allgemein können derartige OCR-Markierungen menschen- bzw. maschinenlesbare Folgen beliebiger Zeichen aufweisen, z.B. Buchstaben oder Zahlen.

Die Solarzelle 1 weist in ihrer aktiven Zone 5 zudem Leiterbahnen 4, 4a, 4b, 41 a, 41 b auf. Diese im Wesentlichen äquidistant zueinander angeordneten und parallel verlaufenden Leiterbahnen 4, 4a, 4b, 41 a, 41 b dienen zum Kontaktieren der Solarzelle 1 und bilden eine so genannte Frontgrid-Elektrode. Die Leiterbahnen 4a, 4b, 41 a, 41 b sind im Ausführungsbeispiel der Figur 1 im Bereich der Datamatrix-Code-Markierung 2 so angeordnet, dass sie einen ausreichenden Abstand zur Markierung 2 haben. Im vorliegenden Fall ist die Datamatrix-Code-Markierung 2 in der Mitte der Solarzelle 1 in dessen aktiver Zone 5 angeordnet und deckt eine Fläche von ungefähr 2 x 2 mm^2 ab. Mittig durch die aktive Zone 5 der Solarzelle 1 verlaufen zwei Leiterbahnen 41 a und 41 b auf die Datamatrix-Code-Markierung 2 zu und knicken vor der Datamatrix-Code-Markierung 2 nach unten bzw. entgegengesetzt dazu nach oben ab, um in die jeweils benachbarten Leiterbahnen 4a, 4b einzumünden. Auf diese Weise kann ein ausreichender Abstand zur Datamatrix-Code-Markierung 2 eingehalten werden, selbst wenn sich die Ausmaße einer Markierung 2, 3 über den Abstand zweier benachbarter Leiterbahnen 4 hinweg erstrecken würde.

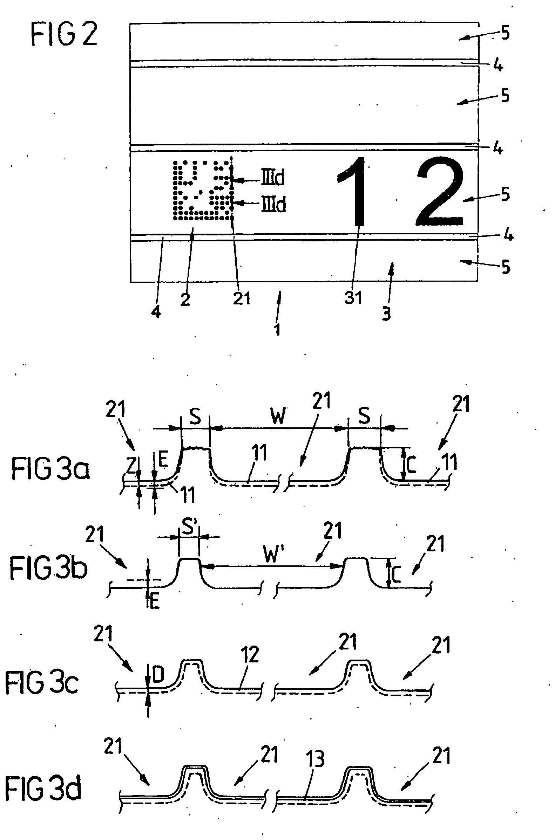

Die Figur 2 zeigt einen im Vergleich zur Figur 1 vergrößerten Ausschnitt der aktiven Zone 5 einer zweiten Ausführungsform einer Solarzelle 1 mit einer Datamatrix-Code-Markierung 2 und einer Serienkennung 3, die ebenfalls als OCR-Markierung ausgebildet ist, wobei die Markierungen 2, 3 mittig zwischen zwei benachbarten Leiterbahnen 4 angeordnet sind. Die Datamatrix-Code-Markierung 2 besteht aus einer Mehrzahl punktförmiger Vertiefungen 21, die in der aktiven Zone 5 auf der Waferoberfläche der Solarzelle 1 eingebracht sind und zusammen die Markierung 2 in Form des Datamatrix-Codes bilden. Die Serienkennung 3 weist einzelne als Ziffern ausgebildete Vertiefungen 31 auf, die jeweils durch eine zusammenhängende, im Vergleich zu den Vertiefungen 21 der Datamatrix-Code-Markierung 2 größerflächige Aussparung in der aktiven Zone 5 auf der Waferoberfläche der Solarzelle 1 gebildet sind.

Sowohl die Datamatrix-Code-Markierung 2 als auch die Serienkennung 3 wurden unter Lasereinwirkung vor dem eigentlichen Prozessieren des Halbleiterwafers zum Herstellen der Solarzelle 1 in der Waferoberfläche ausgebildet. Grundsätzlich ist es denkbar, das Ausbilden einer Markierung 2, 3 auch zu einem späteren Zeitpunkt während des Herstellungsablaufs einer Solarzelle 1 vorzunehmen. Unabhängig vom Zeitpunkt, wann die Markierung im Herstellungsprozess vorgenommen wurde, wird durch die Position der Markierung 2, 3 in der aktiven Zone 5 der Solarzelle 1 gewährleistet, dass diese selbst nach dem Einbau der Solarzelle 1 in ein Solarmodul gut erkennbar und somit einfach auslesbar ist.

Je früher im Herstellungsprozess der Solarzelle 1 die Markierung in die Waferoberfläche eingebracht wird, desto wichtiger ist es, eine ausreichende Tiefe und einen ausreichenden Durchmesser für die Vertiefungen 21, 31 vorzusehen. Dies liegt darin begründet, dass nachfolgende Prozessschritte, wie beispielsweise Ätz- und Abscheidungsschritte, die Tiefe, den Durchmesser und die optische Oberflächenbeschaffenheit der Vertiefungen 21, 31 verändern und somit auf den für das Auslesen der Markierung wesentlichen optischen Kontrast der Markierung 2, 3 Einfluss nehmen.

Abhängig von der konkreten Ausbildung der Prozessschritte wurden die einzelnen punktförmigen Vertiefungen 21 bzw. die die Serienkennung 3 bildenden Vertiefungen 31 so tief erzeugt, dass sie auch durch die nachfolgenden Prozessschritte zum Herstellen der Solarzelle nicht zerstört bzw. zu stark beeinträchtigt wurden, d.h. immer noch, insbesondere maschinell, beispielsweise über eine opto-elektronische Leseeinrichtung für OCR-Markierungen, lesbar sind.

Bevorzugte Maße für das Markieren zu Beginn eines Solarzellen-Herstellungsprozesses werden, beispielhaft für die in den Figuren 3a bis 3d dargestellten Prozessschritte bei der Herstellung einer Solarzelle 1, nachfolgend erläutert.

Figur 3a zeigt eine nicht maßstabsgetreue schematische Schnittdarstellung durch drei benachbart angeordnete Vertiefungen 21 auf der Oberfläche eines noch unbehandelten Halbleiterwafers. Die benachbarten Vertiefungen 21 sind jeweils durch Stege mit der Stegbreite S voneinander beabstandet. Auf den Stegen sind die vom Zersägen der Halbleiterwafer rührenden Rauhigkeiten der Waferoberfläche erkennbar. Im Bereich der drei Vertiefungen 21 ist die Waferoberfläche glatt ausgebildet. Dies liegt darin begründet, dass in diesen Bereichen Halbleitermaterial bei der Laserablation durch Energieeintrag in seiner Mikrostruktur verändert, aber noch nicht verdampft bzw. direkt sublimiert worden ist. Nach dem Abschalten des Laserstrahls bleibt auf der Waferoberfläche durch Energieeintrag in seiner Mikrostruktur verändertes Halbleitermaterial zurück. Dabei bleibt im Gegensatz zur ungestörten kristallinen Mikrostruktur des Halbleiterwafers eine durch den Energieeintrag beeinflusste Zone 11 ("heat affected zone") in den Vertiefungen zurück. Über Pulsenergie, Pulslänge sowie Intensitätsprofil der Laserstrahlung und die eingesetzte Bestrahlungsdauer lassen sich Breite W und Tiefe C der Vertiefungen 21 manipulieren. Über diese Parameter wird auch die Tiefe Z der durch Energieeintrag beeinflussten Zone 11 beeinflusst. Diese Tiefe Z nimmt im Bereich der Vertiefungsflanken entsprechend der lateral geringer werdenden Pulsintensität ab.

Da Halbleiter mit beispielsweise durch den Energieeintrag der Laserstrahlung gestörter und ungestörter kristalliner Mikrostruktur unterschiedliche Ladungsträgerlebensdauern aufweisen, würden die physikalischen Parameter einer Solarzelle auf Basis eines polykristallinen bzw. monokristallinen Halbleiterwafers durch die durch Energieeintrag beeinflussten Zone 11 negativ beeinflusst. Aus diesem Grund werden die durch Energieeintrag beeinflussten Zonen 11 durch einen nachfolgenden Ätzschritt bevorzugt entfernt.

Figur 3b zeigt die Darstellung aus Figur 3a nach einem isotropen Ätzschritt, beispielsweise einer nass-chemischen Ätzung. Durch Konzentration, Temperatur und Einwirkzeit des Ätzmittels lässt sich eine gewünschte Ätztiefen E einstellen, und dadurch Halbleitermaterial kontrolliert entfernen. Es ist erkennbar, dass die geätzte Stegbreite S' im Vergleich zur Stegbreite S um in etwas die doppelte Ätztiefe E abgenommen und die geätzte Vertiefungsbreite W' entsprechend um die doppelte Ätztiefe E zugenommen hat. Aufgrund des isotropen Ätzverhaltens ist die Tiefe C der Vertiefungen im Wesentlichen gleich geblieben. Weiterhin wird aus den vorangehend genannten Gründen die Ätztiefe so eingestellt, dass die in Figur 3a dargestellten, durch Energieeintrag beeinflussten Zonen 11 im Bereich der Vertiefungen 21 vollständig entfernt werden.

Zusätzlich oder gleichzeitig mit dem nass-chemischen Polieren ist es vorteilhaft, den Ätzschritt derart auszugestalten, dass die Waferoberfläche eine so genannte Textur erhält. Dabei handelt es sich um krater- bzw. nadelförmige Strukturen mit Durchmesser bzw. Abständen im Submikrometer- und Mikrometerbereich und Tiefen, die mehrere Mikrometer betragen können.

Die gezielte Textur von Oberflächen und Grenzflächen ist bei Solarzellen allgemein üblich und bekannt. Die feinen Textur-Strukturen führen zu Vielfachreflexionen des darauf treffenden Lichts, wodurch mehr Licht in die Zellen eingekoppelt bzw. eingekoppeltes Licht länger in den Absorptionsstrukturen "gefangen" wird. Auf diese Weise wird letztendlich der Wirkungsgrad der Solarzellen erhöht.

Figur 3c zeigt die Schnittdarstellung aus Figur 3b. In die gezeigte Oberfläche des Halbleiterwafers ist ein Dotierstoff zur Erzeugung eines p-n-Übergangs eingebracht worden. Die Dotiertiefe D beträgt beispielsweise über die gesamte Oberfläche gleichmäßig 0,5µm und als Dotierstoff hat man Phosphor thermisch in die Oberfläche eines p-leitenden Halbleiterwafers eindiffundieren lassen. Auf diese Weise bildet sich eine n-leitende Dotierzone 12 in Form einer Dünnschicht.

Figur 3d zeigt schließlich den schematischen, nicht maßstabsgerechten Querschnitt durch drei benachbart angeordnete Vertiefungen 21 entlang der Schnittlinie III b-IIIb in Figur 2. Im Unterschied zur Darstellung der Figur 3c ist noch eine Antireflexionsschicht 13 aus Siliziumnitrid hinzugekommen, die auf der gesamten Oberfläche des Halbleiterwafers abgeschieden wurde.

Für das Erzeugen von Vertiefungen 21 sind auf dem Markt erhältliche Nd:YAG-Lasermarkiersysteme geeignet. Mit solchen Systemen ließen sich bei Wellenlängen von 1064 nm, Pulsdauern von 20 bis 50 ns und mittleren Laserleistungen von 5 bis 30 W gute Ergebnisse bei der Markierung von Halbleiterwafern erzielen.

Werden die anfangs im Bereich der zukünftigen aktiven Zone einer Solarzelle eingebrachten Markierungen durch nachfolgende Prozessschritte bearbeitet, so müssen dadurch generierte Veränderungen von Maßen und optischer Oberflächeneigenschaften im Hinblick auf die Eignung der bearbeiteten Vertiefungen zum Auslesen von Markierungen berücksichtigt werden.

Grundsätzlich wirkt der systembedingte hohe Absorptionsgrad aktiver Zonen von Solarzellen für sichtbares Licht einer kontrastreichen Darstellung einer in der aktiven Zone angeordneten Markierung von sich aus entgegen, wenn diese beleuchtet wird. Es hat sich als erforderlich herausgestellt, die Vertiefungen deutlich breiter als tief auszubilden. Bei Tiefen von 10 bis 30 µm, bevorzugt 20 µm hat sich ein Durchmesser von 100 µm vor einem anschließenden Ätzschritt bewährt. Die Ätztiefe E des anschließenden Ätzschrittes betrug 5 µm, so dass die durch Energieeintrag der Laserpulse mit den vorangehend genannten Parametern generierten morphologisch beeinflussten Zonen 11 vollständig abgetragen wurden.

Ein weiterer wichtiger Aspekt ist der Abstand der einzelnen Vertiefungen 21, 31 zueinander. Die beispielsweise zwischen den Vertiefungen 21 in Figur 3a gezeigten Stege mit der Stegbreite S bzw. mit der in Figur 3b gezeigten geätzten Stegbreite S' sind für den Kontrast der Markierung 2, 3 beim Auslesen wichtig. Für die vorangehend beschriebene Variante benachbarter Vertiefungen 21 mit runder Grundform sollte die Stegbreite S rund 30 µm betragen. Durch den Ätzschritt wird der Steg im Wesentlichen um die doppelte Ätztiefe E reduziert, so dass in etwa 20 µm geätzte Stegbreite übrig bleiben.

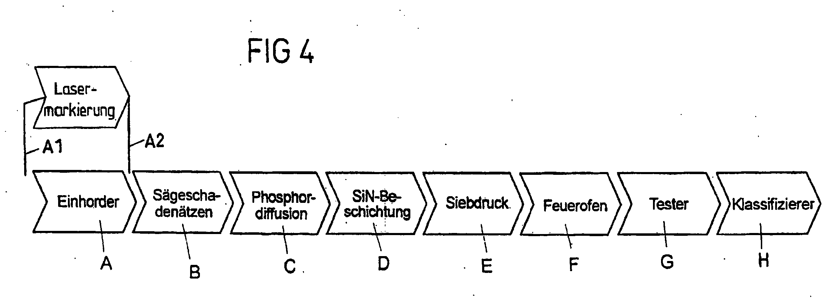

Die Figur 4 gibt anhand eines Ablaufdiagramms einen Überblick über die gesamte Standardprozessierung zum Herstellen einer Solarzelle, die ausschnittsweise in den Figuren 3a bis 3d erläutert wurde.

Der erste Schritt, der beim Hersteller der Solarzelle erfolgt, umfasst eine erste Vereinzelung der Halbleiterwafer am Einhorder A zum Vorbereiten jedes Wafers für die nachfolgenden Prozessschritte. Die Laser-Markierung der aus dem Wafer herzustellenden Solarzellen erfolgt vor der Vereinzelung (Variante A1) oder nach dieser ersten Vereinzelung am Einhorder A (Variante A2). Die zugehörige vergrößerte Darstellung ist in Figur 3a gezeigt. Auf jeden Fall wird der Wafer vor dem ersten eigentlichen Prozessschritt, dem Sägeschadenätzen B, derart markiert, dass die Markierung in der aktiven Zone, der auf diese Weise hergestellten Solarzelle positioniert ist.

Das Sägeschadenätzen B entsprechend der Darstellung aus Figur 3b kann zum Beispiel ein nass-chemisches Polieren beinhalten, bei dem von der Wafervorderseite bzw. von der Waferrückseite Material abgetragen wird. Die Laser-Markierung der Solarzellen ist - wie vorangehend dargestellt - allerdings so ausgeführt, dass sie durch den nass-chemischen Prozessschritt nicht zerstört, bzw zu stark beeinträchtigt wird. Eine bevorzugte Variante des Verfahrens und der damit hergestellten Solarzelle sieht vor, dass die in Figur 3a in den Vertiefungen 21 dargestellten durch Energieeintrag beeinflussten Zonen 11 durch den Ätzschritt des Sägeschadenätzen B entfernt werden.

Vor dem ersten eigentlichen Prozessschritt B wird am Einhorder die Markierung einer Solarzelle gelesen, um die Solarzelle zu identifizieren. Erfolgt das erste Auslesen unmittelbar nach dem Markiervorgang, so ist damit auch eine Funktionskontrolle der Laser-Markiereinheit möglich.

Danach erfolgt das eigentliche Prozessieren des Wafers in den Prozessschritten C bis F. Durch die thermische Phosphordiffusion B wird eine n-Dotierung erzeugt und auf der Oberfläche des p-leitenden Halbleiterwafers entsteht ein großflächiger n-p-Übergang (vergleiche Figur 3c). Nach dem Diffusionsschritt B wird auf der Waferoberfläche eine Antireflexionsschicht in Form einer SiN-Beschichtung D abgeschieden. Auf der SiN-Schicht erfolgt der Siebdruck E mit einer metallhaltigen Silberpaste, insbesondere zur Bildung der Frontgrid-Elektrode, die mittels der thermischen Behandlung im Feuerofen F durch die Antireflexionsschicht D bis zur Kontaktierung der n-dotierten Halbleiterschicht "durchgefeuert" wird. Nach diesem Verfahrensschritt ist der Herstellungsprozess der Solarzelle an und für sich abgeschlossen.

Zur Qualitätskontrolle wird anschließend die Markierung im Tester G zum Testen der Funktion der hergestellten Solarzelle erneut ausgelesen, wodurch ein sicheres Zuordnen der hergestellten Solarzelle zu den vom Tester ermittelten Daten möglich ist. Gleichzeitig können Solarzellen automatisch aussortiert werden, deren Markierung unlesbar ist. Abschließend erfolgt eine Klassifizierung der Solarzelle nach klar definierten Leistungsmerkmalen in unterschiedliche Qualitätsklassen.

Natürlich ist es auch möglich, die Markierungen der einzelnen Solarzellen während des Prozesses, d.h., zwischen zwei Prozessschritten, auszulesen. Damit ist eine einfache lückenlose Rückverfolgbarkeit und Protokollierbarkeit des gesamten Herstellungsprozesses möglich.

### Bezugszeichenliste:

- 1: Solarzelle
- 11: durch Energieeintrag beeinflusste Zone ("heat affected zone")
- 12: Dotierzone
- 13: Antireflexionsschicht
- 2: Markierung als zweidimensionaler Datamatrix Code
- 21: Vertiefung
- 3: Markierung als OCR-lesbare Serienkennung
- 31: Vertiefung
- 4: Leiterbahn
- 4a, 4b: zu den mittigen Leiterbahnen 41 a, 41 b benachbarte Leiterbahnen
- 41a, 41b: mittige Leiterbahn
- 5: aktive Zone der Solarzelle 1
- C: Tiefe der Vertiefungen 21
- D: Diffusionstiefe der Dotierzone 12
- S: Abstand der Vertiefungen 21 vor dem Ätzschritt
- S': Abstand der Vertiefungen 21 nach dem Ätzschritt
- W: Durchmesser der Vertiefungen 21 vor dem Ätzschritt
- W': Durchmesser der Vertiefungen 21 nach dem Ätzschritt
- E: Ätztiefe für den isotropen Ätzschritt
- Z: Tiefe der durch Energieeintrag beeinflussten Zone 11

## Patentansprüche

1. Solarzellen-Markierverfahren, mit den Schritten
- Bereitstellen eines Substrates mit einer Substratoberfläche zum Herstellen einer Solarzelle (1), die eine aktive Zone (5) aufweist, und
- Erzeugen mindestens einer Vertiefung (21, 31) in der Substratoberfläche unter Verwendung von Laserstrahlung, wobei die mindestens eine Vertiefung (21, 31) eine Markierung (2, 3) zum Markieren der Solarzelle (1) bildet, und das Erzeugen der Vertiefung (21, 31) vor einem Durchführen eines Solarzellen-Herstellungsprozesses oder während eines Durchführens eines Solarzellen-Herstellungsprozesses vorgenommen wird,
**dadurch gekennzeichnet, dass**
das Substrat als Halbleiterwafer mit einer Waferoberfläche ausgebildet ist, und die Markierung (2, 3) auf der Waferoberfläche derart positioniert wird, dass die Markierung (2, 3) auf der Vorderseite in der aktiven Zone (5) der aus dem Halbleiterwafer gebildeten Solarzelle (1) liegt.

2. Solarzellen-Markierverfahren gemäß Anspruch 1, **dadurch gekennzeichnet, dass** die mindestens eine Vertiefung (21, 31) mit einer solchen Tiefe erzeugt wird, dass die durch sie gebildete Markierung (2, 3) auch nach Durchführen des gesamten Herstellungsprozesses mittels einer opto-elektronischen Leseeinrichtung lesbar ist.

3. Solarzellen-Markierverfahren gemäß Anspruch 1 oder 2, **dadurch gekennzeichnet, dass** nach dem Erzeugen der mindestens einen Vertiefung (21, 31) ein Ätzschritt derart vorgesehen ist, dass die durch Energieeintrag beeinflussten Zonen (11) an der Waferoberfläche im Bereich der Vertiefung (21, 31) vollständig entfernt werden.

4. Solarzellen-Markierverfahren gemäß Anspruch 3, **dadurch gekennzeichnet, dass** der vorgesehene Ätzschritt derart ausgebildet ist, dass die Waferoberfläche im Bereich der Vertiefungen mit einer höheren Ätzrate geätzt wird als außerhalb.

5. Solarzellen-Markierverfahren gemäß Anspruch 3 oder 4, **dadurch gekennzeichnet, dass** der Ätzschritt als nasschemisches Polieren oder als Trokkenätzschritt (bspw. Plasmaätzen) durchgeführt wird.

6. Solarzellen-Markierverfahren gemäß Anspruch 5, **dadurch gekennzeichnet, dass** durch den Ätzschritt zusätzlich die mit der Markierung (2, 3) versehene Waferoberfläche texturiert wird.

7. Solarzellen-Markierverfahren gemäß einem der vorangehenden Ansprüche, **dadurch gekennzeichnet, dass** die mindestens eine Vertiefung (21, 31) durch Laserabtrag mit einer Tiefe von mehr als 8 µm, bevorzugt mehr als 12 µm, besonders bevorzugt zwischen 15 und 30 µm erzeugt wird.

8. Solarzellen-Markierverfahren gemäß einem der vorangehenden Ansprüche, **dadurch gekennzeichnet, dass** das Größenverhältnis von der Tiefe zum Durchmesser der mindestens einen Vertiefung (21, 31) bei der Erzeugung der Vertiefung (21, 31) größer 1:12, bevorzugt größer 1:10 und besonders bevorzugt im Bereich von 1:7 bis 1:3 beträgt.

9. Solarzellen-Markierverfahren gemäß einem der vorangehenden Ansprüche, **dadurch gekennzeichnet, dass** der Solarzellen-Herstellungsprozess folgende Schritte umfasst:
- die Erzeugung eines großflächigen p-n-Übergangs auf der mit der Markierung (2, 3) versehenen Waferoberfläche, beispielsweise durch thermische Diffusion mit einem Dotierstoff, insbesondere mit Phosphor;
- das Abscheiden einer Antireflexionsschicht auf der mit der Markierung (2, 3) versehenen Waferoberfläche, beispielsweise in Form einer Dünnschicht (13) aus Siliziumnitrid oder Titandioxid
und
- das Aufbringen, Trocknen und Einbrennen einer metallhaltigen Paste in Form eines Leiterbahnen (4) aufweisenden metallischen Elektrodengitters auf der mit der Markierung (2, 3) versehenen Waferoberfläche.

10. Solarzellen-Markierverfahren gemäß Anspruch 9, **dadurch gekennzeichnet, dass** die Leiterbahnen (4) beabstandet zur Markierung (2, 3) angeordnet werden.

11. Solarzellen-Markierverfahren gemäß Anspruch 10, **dadurch gekennzeichnet, dass** die Leiterbahnen (4) äquidistant zueinander angeordnet werden.

12. Solarzellen-Markierverfahren gemäß Anspruch 10 oder 11, **dadurch gekennzeichnet, dass** die Markierung (2, 3) mittig auf dem Halbleiterwafer angeordnet wird und die Leiterbahnen (4) derart angeordnet werden, dass eine erste mittige Leiterbahn (41a) von der einen Seite der Waferoberfläche auf die Markierung (2) zuläuft und eine zweite mittige Leiterbahn (41 b) von der gegenüberliegenden Seite der Waferoberfläche auf die Markierung (2, 3) zuläuft, wobei die erste mittige Leiterbahn (41 a) und die zweite mittige Leiterbahn (41 b) vor einem Kontakt mit der Markierung (2, 3) in entgegen gesetzte Richtungen abknicken und in jeweils benachbarte Leiterbahnen (4a, 4b) einmünden.

13. Solarzellen-Markierverfahren gemäß einem der vorangehenden Ansprüche, **dadurch gekennzeichnet, dass** die Markierung (2, 3), aufgebaut aus einer Mehrzahl von Vertiefungen (21, 31) in Form einer Serienkennzeichnung, eines Datamatrix-Codes oder eines Strichcodes ausgebildet wird.

14. Solarzellen-Markierverfahren gemäß Anspruch 13, **dadurch gekennzeichnet, dass** die Markierung (2) als 14x14 Datamatrix-Code mit einer Kantenlänge von im Wesentlichen 2 mm x 2 mm erzeugt wird.

15. Solarzellen-Markierverfahren gemäß Anspruch 14, **dadurch gekennzeichnet, dass** die Markierung (3) als eine mittels OCR-Verfahren lesbare Serienkennzeichnung erzeugt wird, die eine Mehrzahl an Zeichen aus Ziffern und/oder Buchstaben umfasst, wobei die Zeichen mit einer Höhe von zirka einem Millimeter ausgebildet werden.

16. Solarzellen-Markierverfahren gemäß mindestens einem der Ansprüche 13 bis 15, **dadurch gekennzeichnet, dass** eine Mehrzahl von Markierungen (2, 3) auf der Waferoberfläche erzeugt wird.

17. Solarzelle (1) mit einer photovoltaisch aktiven Zone (5), umfassend eine Markierung (2, 3) aus einer durch Laserabtrag erzeugten Vertiefung (21, 31),
**dadurch gekennzeichnet, dass**
die Solarzelle (1) aus einem Halbleiterwafer mit einer Waferoberfläche hergestellt und die Markierung (2,3) auf der Vorderseite in der Waferoberfläche im Bereich der aktiven Zone (5) der Solarzelle ausgebildet ist.

18. Solarzelle (1) gemäß Anspruch 17, **dadurch gekennzeichnet, dass** die mindestens eine Vertiefung (21, 31) mit einer solchen Tiefe ausgebildet ist, dass die durch sie gebildete Markierung (2, 3) auch nach Durchführen des gesamten Solarzellen-Herstellungsprozesses mittels einer opto-elektronischen Leseeinrichtung lesbar ist.

19. Solarzelle (1) gemäß Anspruch 17 oder 18, **dadurch gekennzeichnet, dass** angrenzende Bereiche (12) im Innern der mindestens einen Vertiefung (21, 31) eine multikristalline oder eine monokristalline Mikrostruktur aufweisen, die durch den Eintrag von Laserenergie im Wesentlichen unbeeinflusst ist.

20. Solarzelle (1) gemäß einem der Ansprüche 17 bis 19, **dadurch gekennzeichnet, dass** die Waferoberfläche im Innern der mindestens einen Vertiefung (21, 31) texturiert ausgebildet ist.

21. Solarzelle (1) gemäß einem der Ansprüche 17 bis 20, **dadurch gekennzeichnet, dass** die mindestens eine Vertiefung (21, 31) mit einer Tiefe von mehr als 8 µm, bevorzugt mehr als 12 µm, besonders bevorzugt zwischen 15 und 30 µm ausgebildet ist.

22. Solarzelle (1) gemäß einem der Ansprüche 17 bis 21, **dadurch gekennzeichnet, dass** die mindestens eine Vertiefung (21, 31) derart ausgebildet ist, dass das Größenverhältnis von der Tiefe zum Durchmesser der mindestens einen Vertiefung (21, 31) größer 1:12, bevorzugt größer 1:10 und besonders bevorzugt im Bereich von 1:7 bis 1:3 beträgt.

23. Solarzelle (1) gemäß einem der Ansprüche 17 bis 22, umfassend
- einen großflächigen p-n-Übergang auf der der Markierung (2, 3) zugewandten Seite des Halbleiterwafers,
- einer Antireflexionsschicht auf der mit der Markierung (2, 3) versehenen Waferoberfläche und
- einem metallischen Elektrodengitter mit einer Mehrzahl von Leiterbahnen (4) auf der mit der Markierung (2, 3) versehenen Waferoberfläche,
wobei die Leiterbahnen (4) beabstandet zur Markierung (2, 3) verlaufen.

24. Solarzelle (1) gemäß Anspruch 23, **dadurch gekennzeichnet, dass** die Markierung (2, 3) mittig auf dem Halbleiterwafer angeordnet ist und die Leiterbahnen (4) derart angeordnet sind, dass eine erste mittige Leiterbahn (41 a) von der einen Seite der Waferoberfläche auf die Markierung (2) zuläuft und eine zweite mittige Leiterbahn (41 b) von der gegenüberliegenden Seite der Waferoberfläche auf die Markierung (2, 3) zuläuft, wobei die erste mittige Leiterbahn (41a) und die zweite mittige Leiterbahn (41b) vor einem Kontakt mit der Markierung (2, 3) in entgegen gesetzte Richtungen abknicken und in jeweils benachbarte Leiterbahnen (4a, 4b) einmünden.

25. Solarzelle (1) gemäß einem der vorangehenden Ansprüche 17 bis 24, **dadurch gekennzeichnet, dass** die Markierung (2, 3), aufgebaut aus einer Mehrzahl von Vertiefungen (21, 31) in Form einer Serienkennzeichnung, eines Datamatrix-Codes oder eines Strichcodes ausgebildet ist.

26. Solarzelle (1) gemäß Anspruch 25, **dadurch gekennzeichnet, dass** die Markierung (2) als 14x14 Datamatrix-Code mit einer Kantenlänge von im Wesentlichen 2mm x 2mm ausgebildet ist.

27. Solarzelle (1) gemäß Anspruch 25, **dadurch gekennzeichnet, dass** die Markierung (3) als eine mittels einer elektro-optischen Leseeinrichtung lesbare Serienkennzeichnung ausgebildet ist, die eine Mehrzahl an Zeichen aus Ziffern und/oder Buchstaben umfasst, wobei die Zeichen mit einer Höhe von zirka einem Millimeter ausgebildet werden.

28. Solarzelle (1) gemäß mindestens einem der Ansprüche 25 bis 27, **dadurch gekennzeichnet, dass** eine Mehrzahl von Markierungen (2, 3) auf der Waferoberfläche ausgebildet sind.

## Claims

1. Solar cell marking method, comprising the following steps:
- providing a substrate having a substrate surface for producing a solar cell (1) having an active zone (5), and
- producing at least one depression (21, 31) in the substrate surface using laser radiation, wherein the at least one depression (21, 31) forms a marking (2, 3) for marking the solar cell (1), and the production of the depression (21, 31) is carried out before carrying out a solar cell production process or during carrying out a solar cell production process,
**characterized in that**
the substrate is embodied as a semiconductor wafer having a wafer surface, and the marking (2, 3) is positioned on the wafer surface in such a way that the marking (2, 3) lies on the front side in the active zone (5) of the solar cell (1) formed from the semiconductor wafer.

2. Solar cell marking method according to Claim 1, **characterized in that** the at least one depression (21, 31) is produced with a depth such that the marking (2, 3) formed by it is readable by means of an opto-electronic reader even after carrying out the entire production process.

3. Solar cell marking method according to Claim 1 or 2, **characterized in that** after producing the at least one depression (21, 31), an etching step is provided in such a way as to completely remove the zones (11) influenced by energy input at the wafer surface in the region of the depression (21, 31).

4. Solar cell marking method according to Claim 3, **characterized in that** the etching step provided is embodied in such a way that the wafer surface is etched with a higher etching rate in the region of the depressions compared with outside the latter.

5. Solar cell marking method according to Claim 3 or 4, **characterized in that** the etching step is carried out as wet-chemical polishing or as a dry etching step (e.g. plasma etching).

6. Solar cell marking method according to Claim 5, **characterized in that** the wafer surface provided with the marking (2, 3) is additionally textured by the etching step.

7. Solar cell marking method according to any of the preceding claims, **characterized in that** the at least one depression (21, 31) is produced by laser removal with a depth of more than 8 µm, preferably more than 12 µm, particularly preferably between 15 and 30 µm.

8. Solar cell marking method according to any of the preceding claims, **characterized in that** the size ratio of the depth to the diameter of the at least one depression (21, 31) when producing the depression (21, 31) is greater than 1:12, preferably greater than 1:10 and particularly preferably in the range of 1:7 to 1:3.

9. Solar cell marking method according to any of the preceding claims, **characterized in that** the solar cell production process comprises the following steps:
- producing a large-area p-n junction on the wafer surface provided with the marking (2, 3) for example by thermal diffusion with a dopant, in particular with phosphorus;
- depositing an anti-reflection layer on the wafer surface provided with the marking (2, 3) for example in the form of a thin-film layer (13) of silicon nitride or titanium dioxide, and
- applying, drying and firing a metal-containing paste in the form of a metallic electrode grid having conductor tracks (4) on the wafer surface provided with the marking (2, 3).

10. Solar cell marking method according to Claim 9, **characterized in that** the conductor tracks (4) are arranged at a distance from the marking (2, 3).

11. Solar cell marking method according to Claim 10, **characterized in that** the conductor tracks (4) are arranged equidistantly with respect to one another.

12. Solar cell marking method according to Claim 10 or 11, **characterized in that** the marking (2, 3) is arranged centrally on the semiconductor wafer and the conductor tracks (4) are arranged in such a way that a first central conductor track (41a) extends from one side of the wafer surface towards the marking (2) and a second central conductor track (41b) extends from the opposite side of the wafer surface towards the marking (2, 3), wherein the first central conductor track (41a) and the second central conductor track (41b) bend away in opposite directions before contact with the marking (2, 3) and lead into respectively adjacent conductor tracks (4a, 4b).

13. Solar cell marking method according to any of the preceding claims, **characterized in that** the marking (2, 3) is embodied in a manner constructed from a plurality of depressions (21, 31) in the form of a serial identification, a data matrix code or a barcode.

14. Solar cell marking method according to Claim 13, **characterized in that** the marking (2) is produced as a 14x14 data matrix code having an edge length of substantially 2 mm x 2 mm.

15. Solar cell marking method according to Claim 14, **characterized in that** the marking (3) is produced as a serial identification which is readable by means of OCR methods and which comprises a plurality of characters composed of numerals and/or letters, wherein the characters are embodied with a height of approximately 1 millimetre.

16. Solar cell marking method according to at least one of Claims 13 to 15, **characterized in that** a plurality of markings (2, 3) are produced on the wafer surface.

17. Solar cell (1) having a photovoltaically active zone (5) comprising a marking (2, 3) composed of a depression (21, 31) produced by laser removal, **characterized in that**
the solar cell (1) is produced from a semiconductor wafer having a wafer surface and the marking (2, 3) is embodied on the front side in the wafer surface in the region of the active zone (5) of the solar cell.

18. Solar cell (1) according to Claim 17, **characterized in that** the at least one depression (21, 31) is embodied with a depth such that the marking (2, 3) formed by it is readable by means of an opto-electronic reader even after carrying out the entire solar cell production process.

19. Solar cell (1) according to Claim 17 or 18, **characterized in that** adjoining regions (12) in the interior of the at least one depression (21, 31) have a multicrystalline or a monocrystalline microstructure which is substantially uninfluenced by the input of laser energy.

20. Solar cell (1) according to any of Claims 17 to 19, **characterized in that** the wafer surface in the interior of the at least one depression (21, 31) is embodied in textured fashion.

21. Solar cell (1) according to any of Claims 17 to 20, **characterized in that** the at least one depression (21, 31) is embodied with a depth of more than 8 µm, preferably more than 12 µm, particularly preferably between 15 and 30 µm.

22. Solar cell (1) according to any of Claims 17 to 21, **characterized in that** the at least one depression (21, 31) is embodied in such a way that the size ratio of the depth to the diameter of the at least one depression (21, 31) is greater than 1:12, preferably greater than 1:10 and particularly preferably in the range of 1:7 to 1:3.

23. Solar cell (1) according to any of Claims 17 to 22, comprising
- a large-area p-n junction on that side of the semiconductor wafer which faces the marking (2, 3),
- an anti-reflection layer on the wafer surface provided with the marking (2,3), and
- a metallic electrode grid having a plurality of conductor tracks (4) on the wafer surface provided with the marking (2, 3),
wherein the conductor tracks (4) extend at a distance from the marking (2,3).

24. Solar cell (1) according to Claim 23, **characterized in that** the marking (2, 3) is arranged centrally on the semiconductor wafer and the conductor tracks (4) are arranged in such a way that a first central conductor track (41a) extends from one side of the wafer surface towards the marking (2) and a second central conductor track (41b) extends from the opposite side of the wafer surface towards the marking (2, 3), wherein the first central conductor track (41a) and the second central conductor track (41b) bend away in opposite directions before contact with the marking (2, 3) and lead into respectively adjacent conductor tracks (4a, 4b).

25. Solar cell (1) according to any of the preceding Claims 17 to 24, **characterized in that** the marking (2, 3) is embodied in a manner constructed from a plurality of depressions (21, 31) in the form of a serial identification, a data matrix code or a barcode.

26. Solar cell (1) according to Claim 25, **characterized in that** the marking (2) is embodied as a 14x14 data matrix code having an edge length of substantially 2 mm x 2 mm.

27. Solar cell (1) according to Claim 25, **characterized in that** the marking (3) is embodied as a serial identification which is readable by means of an electro-optical reader and which comprises a plurality of characters composed of numerals and/or letters, wherein the characters are embodied with a height of approximately 1 millimetre.

28. Solar cell (1) according to at least one of Claims 25 to 27, **characterized in that** a plurality of markings (2, 3) are embodied on the wafer surface.

## Revendications

1. Procédé de marquage de cellules solaires, avec les étapes :
- préparation d'un substrat doté d'une surface de substrat pour la fabrication d'une cellule solaire (1), comportant une zone active (5), et
- obtention d'au moins une dépression (21, 31) dans la surface de substrat par application d'une radiation laser, dans lequel l'au moins une dépression (21, 31) forme un marquage (2, 3) marquant la cellule solaire (1), et l'obtention de la dépression (21, 31) est effectuée avant une réalisation d'un processus de fabrication de cellules solaires ou pendant une réalisation d'un processus de fabrication de cellules solaires,
**caractérisé en ce que** le substrat est conçu comme tranche semi-conductrice dotée d'une surface de tranche, et le marquage (2, 3) est positionné sur la surface de tranche de telle sorte que le marquage (2, 3) se trouve au front dans la zone active (5) de la cellule solaire (1) formée sur la tranche semi-conductrice.

2. Procédé de marquage de cellules solaires selon la revendication 1, **caractérisé en ce que** l'au moins une dépression (21, 31) est obtenue avec une profondeur telle que le marquage (2, 3) formé par celle-ci est également lisible après réalisation du processus total de fabrication au moyen d'un dispositif de lecture optoélectronique.

3. Procédé de marquage de cellules solaires selon la revendication 1 ou 2, **caractérisé en ce qu'**après l'obtention de l'au moins une dépression (21, 31) une étape de gravure est prévue de telle sorte que les zones (11) affectées par un apport en énergie sur la surface de tranche dans le domaine de la dépression (21, 31) sont complètement éliminées.

4. Procédé de marquage de cellules solaires selon la revendication 3, **caractérisé en ce que** l'étape de gravure prévue est conçue de telle sorte que la surface de tranche dans le domaine de la dépression est gravée avec une vitesse de gravure plus élevée qu'à l'extérieur de ce domaine.

5. Procédé de marquage de cellules solaires selon la revendication 3 ou 4, **caractérisé en ce que** l'étape de gravure est réalisée comme polissage par voie chimique humide ou comme étape de gravure à sec (par exemple gravure au plasma).

6. Procédé de marquage de cellules solaires selon la revendication 5, **caractérisé en ce que** la surface de tranche prévue avec le marquage (2, 3) est en outre texturée par l'étape de gravure.

7. Procédé de marquage de cellules solaires selon l'une des revendications précédentes, **caractérisé en ce que** l'au moins une dépression (21, 31) est obtenue par érodage au laser avec une profondeur supérieure à 8 µm, de préférence supérieure à 12 µm, plus particulièrement entre 15 et 30 µm.

8. Procédé de marquage de cellules solaires selon l'une des revendications précédentes, **caractérisé en ce que** le ratio de la profondeur au diamètre de l'au moins une dépression (21, 31) lors de l'obtention de l'au moins une dépression (21, 31) est supérieur à 1:12, de préférence supérieur à 1:10 et plus particulièrement dans un intervalle de 1:7 à 1:3.

9. Procédé de marquage de cellules solaires selon l'une des revendications précédentes, **caractérisé en ce que** le processus de fabrication de cellules solaires comprend les étapes suivantes :
- l'obtention d'une jonction p-n de grande surface sur la surface de tranche prévue dotée du marquage (2, 3), par exemple par diffusion thermique avec un dopant, en particulier avec du phosphore ;
- le dépôt d'une couche antireflet sur la surface de tranche prévue dotée du marquage (2, 3), par exemple sous forme d'une couche mince (13) de nitrure de silicium ou de dioxyde de titane
et
- l'application, le séchage et la cuisson d'une pâte contenant du métal sous forme d'une grille d'électrode métallique comportant des bandes conductrices (4) sur la surface de tranche prévue dotée du marquage (2, 3).

10. Procédé de marquage de cellules solaires selon la revendication 9, **caractérisé en ce que** les bandes conductrices (4) sont agencées écartées du marquage (2, 3).

11. Procédé de marquage de cellules solaires selon la revendication 10, **caractérisé en ce que** les bandes conductrices (4) sont agencées à équidistance l'une de l'autre.

12. Procédé de marquage de cellules solaires selon la revendication 10 ou 11, **caractérisé en ce que** le marquage (2, 3) est agencé au centre de la tranche semi-conductrice et les bandes conductrices (4) sont agencées de telle sorte qu'une première bande conductrice centrale (41a) va d'un côté de la surface de tranche vers le marquage (2) et une deuxième bande conductrice centrale (41b) va du côté opposé de la surface de tranche vers le marquage (2, 3), dans lequel la première bande conductrice centrale (41a) et la deuxième bande conductrice centrale (41b) plient dans des directions opposées avant un contact avec le marquage (2, 3) et débouchent dans des bandes conductrices adjacentes respectives (4a, 4b).

13. Procédé de marquage de cellules solaires selon l'une des revendications précédentes, **caractérisé en ce que** le marquage (2, 3) est constitué d'une pluralité de dépressions (21, 31) sous forme d'une désignation de série, d'un code Datamatrix ou d'un code-barres.

14. Procédé de marquage de cellules solaires selon la revendication 13, **caractérisé en ce que** le marquage (2) est obtenu comme code Datamatrix 14×14 avec une longueur d'arête d'essentiellement 2 mm × 2 mm.

15. Procédé de marquage de cellules solaires selon la revendication 14, **caractérisé en ce que** le marquage (3) est obtenu comme désignation de série lisible au moyen d'un procédé OCR, comprenant une pluralité de signes numériques et/ou alphabétiques, dans lequel les signes sont formés avec une hauteur d'environ un millimètre.

16. Procédé de marquage de cellules solaires selon au moins l'une des revendications 13 à 15, **caractérisé en ce qu'**une pluralité de marquages (2, 3) sont obtenus sur la surface de tranche.

17. Cellule solaire (1) dotée d'une zone photovoltaïque active (5), comprenant un marquage (2, 3) à partir d'une dépression (21, 31) obtenue par érodage au laser, **caractérisée en ce que** la cellule solaire (1) est fabriquée à partir d'une tranche semi-conductrice dotée d'une surface de tranche et le marquage (2, 3) est formé au front sur la surface de tranche dans le domaine de la zone active (5) de la cellule solaire (1).

18. Cellule solaire (1) selon la revendication 17, **caractérisée en ce que** l'au moins une dépression (21, 31) est conçue avec une profondeur telle que le marquage (2, 3) formé par celle-ci est également lisible après réalisation du processus total de fabrication de cellules solaires au moyen d'un dispositif de lecture optoélectronique.

19. Cellule solaire (1) selon la revendication 17 ou 18, **caractérisée en ce que** des domaines adjacents (12) à l'intérieur de l'au moins une dépression (21, 31) possèdent une microstructure polycristalline ou monocristalline, qui n'est essentiellement pas affectée par un apport en énergie laser.

20. Cellule solaire (1) selon l'une des revendications 17 à 19, **caractérisée en ce que** la surface de tranche est conçue comme texturée à l'intérieur de l'au moins une dépression (21, 31).

21. Cellule solaire (1) selon l'une des revendications 17 à 20, **caractérisée en ce que** l'au moins une dépression (21, 31) est conçue avec une profondeur supérieure à 8 µm, de préférence supérieure à 12 µm, plus particulièrement entre 15 et 30 µm.

22. Cellule solaire (1) selon l'une des revendications 17 à 21, **caractérisée en ce que** l'au moins une dépression (21, 31) est conçue de telle sorte que le ratio de la profondeur au diamètre de l'au moins une dépression (21, 31) est supérieur à 1:12, de préférence supérieur à 1:10 et plus particulièrement dans un intervalle de 1:7 à 1:3.

23. Cellule solaire (1) selon l'une des revendications 17 à 22, comprenant
- une jonction p-n de grande surface sur la surface de tranche prévue dotée du marquage (2, 3),
- une couche antireflet sur la surface de tranche prévue dotée du marquage (2, 3) et
- une grille d'électrode métallique dotée d'une pluralité de bandes conductrices (4) sur la surface de tranche prévue dotée du marquage (2, 3)
dans lequel les bandes conductrices (4) sont à distance du marquage (2, 3).

24. Cellule solaire (1) selon la revendication 23, **caractérisée en ce que** le marquage (2, 3) est agencé au centre de la tranche semi-conductrice et les bandes conductrices (4) sont agencées de telle sorte qu'une première bande conductrice centrale (41a) va d'un côté de la surface de tranche vers le marquage (2) et une deuxième bande conductrice centrale (41b) va du côté opposé de la surface de tranche vers le marquage (2, 3), dans lequel la première bande conductrice centrale (41a) et la deuxième bande conductrice centrale (41b) plient dans des directions opposées avant un contact avec le marquage (2, 3) et débouchent dans des bandes conductrices adjacentes respectives (4a, 4b).

25. Cellule solaire (1) selon l'une des revendications précédentes 17 à 24, **caractérisée en ce que** le marquage (2, 3) est constitué d'une pluralité de dépressions (21, 31) sous forme d'une désignation de série, d'un code Datamatrix ou d'un code-barres.

26. Cellule solaire (1) selon la revendication 25, **caractérisée en ce que** le marquage (2) est conçu comme code Datamatrix 14×14 avec une longueur d'arête d'essentiellement 2mm × 2mm.

27. Cellule solaire (1) selon la revendication 25, **caractérisée en ce que** le marquage (3) est conçu comme désignation de série lisible au moyen d'un dispositif de lecture optoélectronique, comprenant une pluralité de signes numériques et/ou alphabétiques, dans lequel les signes sont formés avec une hauteur d'environ un millimètre.

28. Cellule solaire (1) selon au moins l'une des revendications 25 à 27, **caractérisée en ce qu'**une pluralité de marquages (2, 3) sont conçus sur la surface de tranche.
